# EUROPEAN PATENT APPLICATION

(11) **EP 4 507 201 A1**
(43) Date of publication of application: **12.02.2025**
(21) Application number: 24157928.3
(22) Date of filing: 15.02.2024
(51) Int. Cl.: H03K 19/173, H03K 19/17724

(54) **PROGRAMMABLE LOGIC DEVICE AND METHODS OF IMPLEMENTING LOGIC CIRCUITS TO IT**

(30) Priority: 07.08.2023 JP 2023128473
(71) Applicant: National University Corporation Kumamoto University, Kumamoto 860-8555 (JP)
(72) Inventor: IIDA, Masahiro, Kumamoto, 8608555 (JP)
(74) Representative: Dennemeyer & Associates S.A.

(57) **Abstract**

In the conventional eFPGAs, there have been two challenges: the first one being size reduction of the logic cells to improve the implemented logic density, and the second one being minimization of the speed difference with the ASIC. According to the present embodiment, there is provided a method for configuring a programmable logic circuit represented by a gate-level netlist, wherein this is done by assigning the gate-level netlist to a 4-input, 3-output combinational logic cell, which is composed of a combination of 3 of 2-input (m-input) basic logic cells, wherein the combinational logic cell covers 3 (n) nodes constituting a graph of the netlist.

## Description

### CROSS-REFERENCE TO RELATED APPLICATION

This application claims the benefit of Japanese Patent Application No. 2023-128473, filed on August 7, 2023, which is hereby incorporated by reference.

### FIELD OF THE INVENTION

The present invention relates to a programmable logic circuit device and a configuration method thereof suitable for incorporating in application-specific integrated circuits (ASICs) such as SoCs.

### BACKGROUND OF THE INVENTION

There are IC products called ASICs (Application Specific Integrated Circuits), which are custom-designed and provided for specific applications. ASICs are semiconductor integrated circuits designed and manufactured for specific devices and/or applications by combining required logic functions, but no change may be made to the on-board logic functions after the manufacturing.

However, in recent years, as ASICs grew in scale and cost, there have been increasingly more cases where logic upgrade is desirable due to the a problem discovered after the manufacturing, and/or cases where adding a new function is desirable. Accordingly, schemes have been adopted to enable problem corrections and/or function additions, wherein a programmable logic circuit block such as a FPGA (Field Programmable Gate Array) device is incorporated into the ASIC. Here, the FPGA section onboard the ASIC is called an "eFPGA (Embedded FPGA)."

Logic cells of conventional eFPGAs use LUTs (Look-Up Tables) representing truth tables "as is." For memories used for LUTs, SRAMs are used for standard FPGAs not for onboarding ASICs, whereas in ASICs, designs using many small SRAMs are not easy. Thus, for eFPGAs in ASICs, FFs (Flip-Flops) are used. However, since FFs generally require an area several times (e.g., 6-10 times) larger compared to SRAMs, eFPGAs require areas several times larger than standard FPGAs for logic cells capable of implementing the same number of logics. For this reason, certain problems exist from the viewpoint of the implemented logic density.

Also, a logic cell using a LUT may implement a logic function with up to the number of inputs to the LUT. For example, a 4-input LUT may implement a logic function with up to four variables. The number of required memories in order to configure the LUT is two to the power of the number of inputs, and when the number of inputs increases, the number of memories increases exponentially. On the other hand, the speed of the implemented logic circuit is proportional to the number of levels (the number of logic levels) across the LUT. In general, there is a trade-off in that when the number of inputs of a LUT increases, the number of logic levels decreases; and vice versa.

Therefore, decreasing the number of inputs to LUTs used for logic cells of eFPGA will reduce the number of memories, allowing to achieve size reduction, but the number of logic levels will increase and cause a concern for slowdown. An eFPGA onboard an ASIC becomes more difficult to control if there is a speed difference with the other parts of the ASIC, and therefore, it is desirable not to slow down the circuit on the eFPGA.

### SUMMARY OF THE INVENTION

As has been described, in the conventional eFPGAs, there are two challenges: the first one being size reduction of the logic cells (improving the implemented logic density), and the second one being minimization of the speed difference with the ASIC; and there is needed a programmable logic circuit capable of solving these challenges simultaneously.

Considering the above situation, the purpose of the present invention is to provide a programmable logic circuit with a novel structure capable of solving the challenges described above.

In order to overcome the above challenges, the inventor of the present invention conceived that logic cell structures different from the conventional LUTs may be realized by focusing on the netlist structure, a form of representation for implemented logic circuits, and completed the present invention.

According to the present invention, the following invention is provided.
(1) A programmable logic circuit, comprising:
   a basic logic cell for configuring a plurality of nodes of a gate-level netlist,
   wherein the basic logic cell is a programmable circuit configured by adding one or more programmable NOT circuits to a basic logic operation element and made programmable to switch inputs and outputs of the basic logic cell depending on connection relationships of nodes in the gate-level netlist.
(2) The programmable logic circuit of the above (1), further comprising:
   a combinational logic cell composed of a combination of a plurality of the basic logic cells,
   wherein the combinational logic cell comprises a plurality of basic logic cells for covering a plurality of nodes constituting a graph of the netlist.
(3) The programmable logic circuit of the above (2), wherein
   the combinational logic cell is a logic cell of (m-1)×n+1 inputs and n outputs, having n of m-input basic logic cells with their input signals switch-ably combined and connected, in order to represent two or more patterns of node connections.
(4) The programmable logic circuit of the above (3), wherein
   the combinational logic cell comprises:
   a switching circuit for switching connection relationships of basic logic nodes in order
   to implement two or more patterns of node connections.
(5) The programmable logic circuit of the above (4), wherein
   the switching circuit is a multiplexer.
(6) The programmable circuit of the above (3), further comprising:
   a memory for retaining switching information of the switching circuit,
   wherein the switching information is information for programming the basic logic cells according to the connection relationships of the nodes constituting the netlist.
(7) A method for configuring a programmable logic circuit, wherein
   nodes constituting a gate-level netlist are assigned to a programmable logic cell, and
   the programmable logic cell is made programmable to switch inputs and outputs of the logic cell depending on connection relationships of the nodes.
(8) The method for configuring a programmable logic circuit of the above (7), comprising the steps of:
   assigning the gate-level netlist to a combinational logic cell composed of a combination of n of m-input basic logic cells, wherein the combinational logic cell covers n nodes constituting a graph of the netlist; and
   configuring the combinational logic cell, the n of m-input basic logic cells, as a logic cell of (m-1)×n+1 inputs and n outputs with their input signals switch-ably combined and connected, in order to represent two or more patterns of connection relationships among the covered plurality of nodes.
(9) The method of the above (8), further comprising the step of
   assigning the basic logic cells to nodes of a gate-level netlist,
   wherein the basic logic cells are programmable circuits configured by adding programmable NOT circuits to basic logic operation elements, and
   made programmable to switch inputs and outputs of the basic logic cells depending on connection relationships of the nodes in the netlist.
(10) The method of the above (8), further comprising the step of
   disposing a switching circuit for switching connection relationships of basic logic nodes between the basic logic nodes in the combinational logic cell in order to implement two or more patterns of node connections.
(11) The method of the above (9), further comprising the step of
   programming switching information of the connection relationships in the basic logic cells according to the connection relationships of the nodes constituting the netlist.

According to the present invention, the number of memories constituting the logic may be reduced to a number generally proportional to the number of inputs. Accordingly, the logic may be constituted with a very small number of memories compared to when the logic is constituted with the conventional SRAM-based LUTs. Also, since the speed of the implemented logic circuit depends on the netlist, the effect of speed increase due to the number of logic cell levels is small unlike when constituted with conventional LUTs.

Note that features and/or other configurations of the present invention view from other aspects are shown in the following description of embodiments of the invention and accompanying drawings.

### BRIEF DESCRIPTION OF THE DRAWINGS

Figs. 1 are schematic views showing gate-level technology mapping when assigned to conventional LUTs;
Figs. 2 are schematic structural views showing a conventional LUT;
Figs. 3 are explanatory views for describing a concept of the present invention;
Figs. 4 are explanatory views for describing connection patterns of nodes in one embodiment of the present invention;
Figs. 5 are schematic structural views showing configuration of a 2-node, 4-input combinational logic cell in one embodiment of the present invention;
Figs. 6 are explanatory views for describing technology mapping of a gate-level netlist in one embodiment of the present invention;
Figs. 7 are tables showing performance comparisons between logic cells of conventional LUTs and the present embodiment of the present invention;
Figs. 8 are schematic views showing PA circuit configurations in one embodiment of the present invention;
Figs. 9 are schematic views showing configuration examples of a PX circuit depending on different basic logic operation elements in one embodiment of the present invention;
Figs. 10 are schematic views showing configuration examples of a PX circuit depending on different basic logic operation elements in one embodiment of the present invention;
Figs. 11 are explanatory views describing node connection patterns implemented by a combinational logic cell in one embodiment of the present invention;
Fig. 12 is a schematic structural view showing a combinational logic cell in one embodiment of the present invention;
Figs. 13 are explanatory views showing connection patterns of four nodes in one embodiment of the present invention;
Fig. 14 is a schematic structural view showing a combinational logic cell in one embodiment of the present invention;
Fig. 15 is a schematic structural view showing a combinational logic cell in one embodiment of the present invention;
Fig. 16 is a schematic structural view showing a combinational logic cell in one embodiment of the present invention;
Fig. 17 is a schematic structural view showing a combinational logic cell in one embodiment of the present invention;
Figs. 18 are explanatory views showing four node connection patterns and combination patterns of basic logic cells in one embodiment of the present invention;
Fig. 19 is a schematic structural view showing a combinational logic cell in one embodiment of the present invention;
Fig. 20 is an explanatory view showing a gate-level netlist;
Fig. 21 is an explanatory view of when a gate-level netlist is assigned to conventional LUTs;
Fig. 22 is an explanatory view of when a gate-level netlist is assigned to conventional LUTs;
Fig. 23 is an explanatory view of when a gate-level netlist is assigned to conventional LUTs;
Fig. 24 is an explanatory view of when a gate-level netlist is assigned to conventional LUTs;
Figs. 25 are explanatory views for describing steps of assigning a gate-level netlist to logic cells according to embodiments of the present invention;
Fig. 26 is an explanatory view for describing steps of assigning a gate-level netlist to logic cells according to one embodiment of the present invention; and
Fig. 27 is an explanatory view for describing steps of assigning a gate-level netlist to logic cells according to one embodiment of the present invention.

### DETAILED DESCRIPTION OF THE INVENTION

One embodiment according to the present invention will be described below with reference to accompanying drawings.

### 1. Basic Concept

In general, performance of logic cells used for a FPGA is measured by how few logics can cover the implemented circuitry, that is, a gate-level netlist; and an operation speed of the logic cell-level netlist after coverage.

Here, covering a gate-level netlist with logic cells is called "technology mapping." Also, the gate-level netlist is represented with a graph of NAND gates (NAND graph) and/or a graph of AND gates and NOT gates (AIG (AND-Inverter graph)).

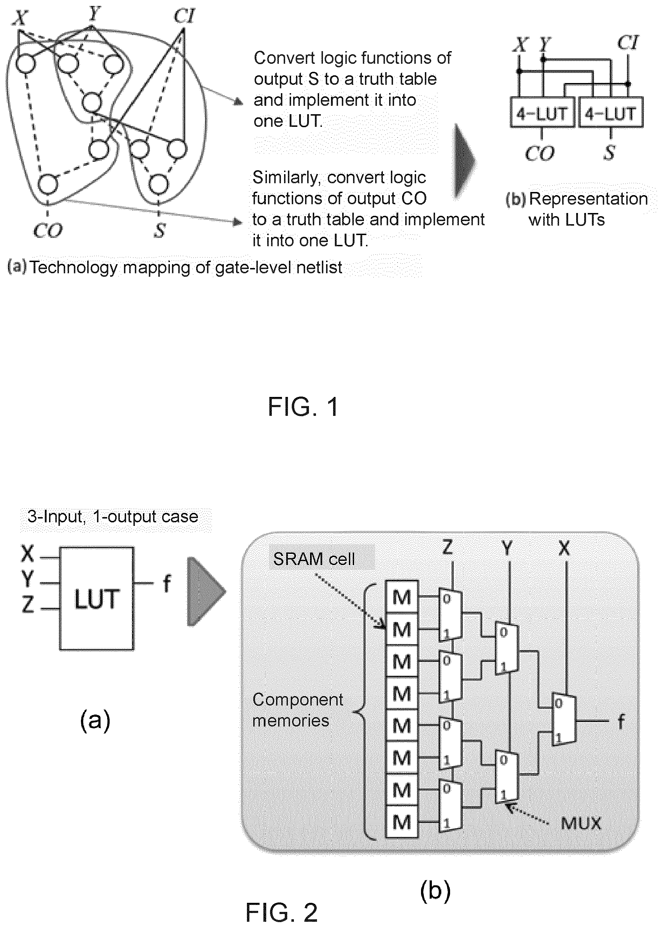

Fig. 1 shows a technology mapping of a gate-level netlist for implementing conventional LUTs. As for the conventional LUTs, in case of a 3-input LUT (3-LUT) as shown in Fig. 2 (a), it is configured to employ SRAMs as their component memories (M) as shown in Fig. 2 (b), and use an input value (X, Y, Z) to select a truth-value stored in the SRAMs to output (f) the truth-value. Such a LUT provides for a logic function by storing a truth table in its component memories.

In the technology mapping example using the above conventional LUT (the example shown in Fig. 2 (a)), logic functions of outputs S and CO of Fig. 1 (a) are converted to truth tables, respectively, and each of them are implemented to different LUTs (two 4-LUTs) as shown in Fig. 1 (b).

In contrast, a logic cell of the present embodiment employs a logic focusing on a structure itself of a gate netlist.

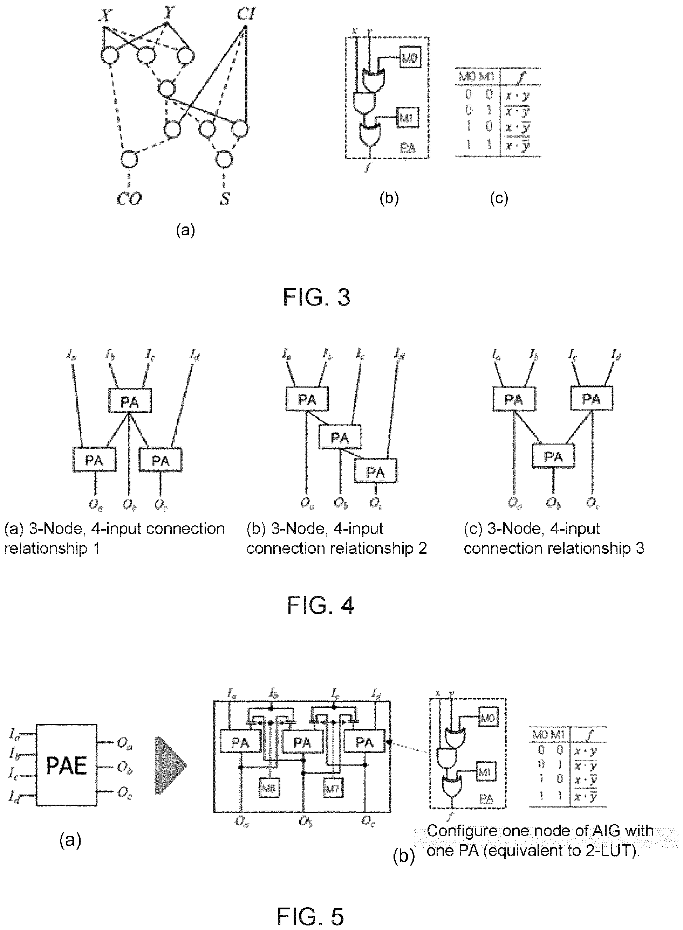

In other words, in one embodiment of the present invention, as shown in Fig. 3 (a), in the AIG (And Inverter Gate), which is a gate-level netlist, a combination of an AND gate (o) and a NOT gate (broken line part of edges) is regarded as a node, and a wire between nodes are regarded as an edge. Then, the above nodes are implemented as a basic logic cell (PA circuit: programmable AND circuit) as shown in Fig. 3 (b). Fig. 3(c) is a conceptual diagram showing combinations of memory values stored in memories M0, M1 and an output f for programming the PA circuit.

As for the number of connection patterns among the above nodes (basic logic cells), if the number of cells included in the logic cell combination (the number of basic logic cells) is, for example, three (four inputs), the number patterns will be three, as in the three patterns (a) to (c) of Fig. 4. In other words, Fig. 4 (a) shows a pattern in which one PA circuit is in a first layer and two PA circuits are in a second layer; Fig. 4 (b) shows a pattern in which three PA circuits are serially positioned across from the first layer to a third layer; and Fig. 4 (c) shows a pattern in which two PA circuits are in the first layer and one PA circuit is in the second layer. When considering a configuration of a 4-input, 3-output combinational logic cell (PAE circuit) (Fig. 5 (a)) for implementing all of the three patterns, the configuration will have three PA circuits (basic logic cells) switch-ably connected as shown in Fig. 5 (b).

As such, the "basic logic cell" and the "combinational logic cell" composed of a combination of the basic logic cells (hereafter, may be referred to as "PAE circuit") are the foundation of the present invention.

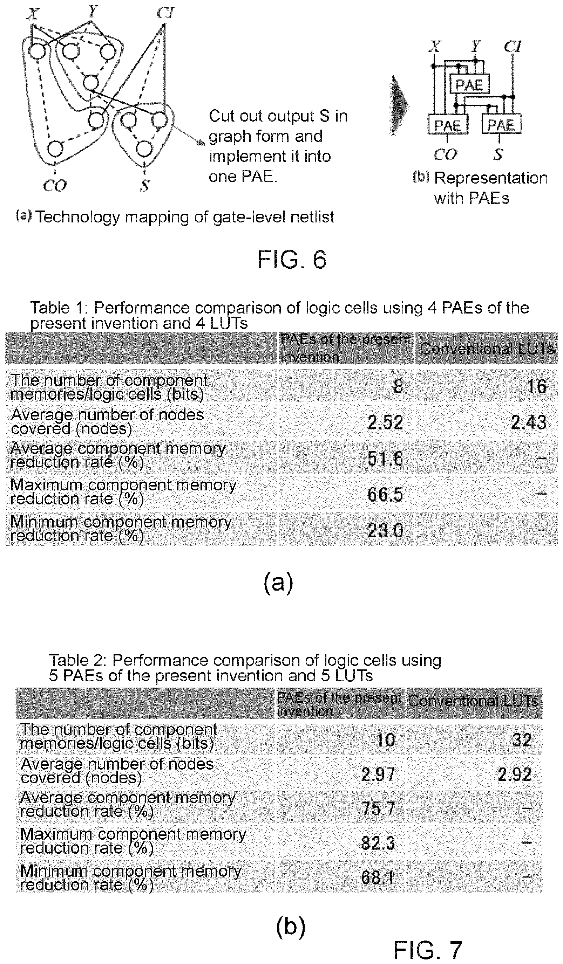

Accordingly, if implemented as a PAE circuit described above, a gate-level netlist which is the same as the above-mentioned conventional LUT example (Fig. 1 (a)) will be as shown in Figs. 6 (a), (b).

### 2. Performance Comparisons

Performance comparisons between a logic cell using conventional LUTs and a logic cell according to the present embodiment described above are shown in Figs. 7.

The comparison example shown in Fig. 7 (a) is comparing logic cells having the same four inputs.

Firstly, as for the number of memories used, in the case of the conventional 4-input (4-LUTs), the number of memories is 16 bits, whereas the 4-input PAE circuit of the present embodiment uses 8 bits, a half of the 4-LUTs.

Further, the average cover rate for the netlist of the present embodiment is 2.52 nodes, which is greater than 2.43 nodes of the LUT. As a result, in an evaluation using 29 types of benchmark circuits, the present embodiment achieves 51.6% of average component memory reduction rate, cutting down the component memories down to half. In addition, the maximum component memory reduction rate is 66.5%, and the minimum component memory reduction rate is 23.0%, reducing more memories than the conventional LUTs.

It should be noted that the number of inputs of the logic cell, PAE of the present embodiment is not limited to four as described above. For example, when increasing the number of inputs (equivalent to increasing the number of PA nodes in a logic cell), in the present embodiment, the number of component memories of a logic cell is proportional to the number of PA nodes. On the other hand, the number of component memories of the LUT is proportional to the power of the number of inputs, increasing the performance gap.

Fig. 7 (b) shows a performance comparison between the present embodiment and a conventional logic cell when the number of inputs is five. According to this, the component memory reduction rates of the present embodiment are on average 75.7%, maximum 82.3%, and minimum 68.1%, indicating that the performance differences have increased.

The basic logic cell, combinational logic cell, and netlist mapping of the present embodiment will be discussed in detail below.

### 3. Basic Logic Cell

Firstly, a basic logic cell will be described.

The basic logic cell (PA circuit) discussed in the above section on the basic concepts of the present invention was an example implementing AND gates and NOT gates in AIG, but the basic logic cell of the present invention may be any configuration of "Px circuits" ("X" means not limited to AND gates), which are basic logic operation elements with added programmable NOT circuits; and the basic logic cells are not limited to PA circuits.

In other words, as described above, a netlist representing logic circuits is a graph showing logic circuits with basic logic operation elements as nodes, such as AND gates, OR gates, and NOT gates; and edges connecting those elements. A netlist generated with NAND gates as nodes is called a "NAND graph," and a netlist generated with AND gates and NOT gates as nodes is called an "AIG (AND-Inverter graph)," but a netlist may be generated with NOR gates as nodes, or with OR gates and NOT gates as nodes as well. In other words, in the present embodiment, if nodes are a set of universal functions, any logic circuits may be represented.

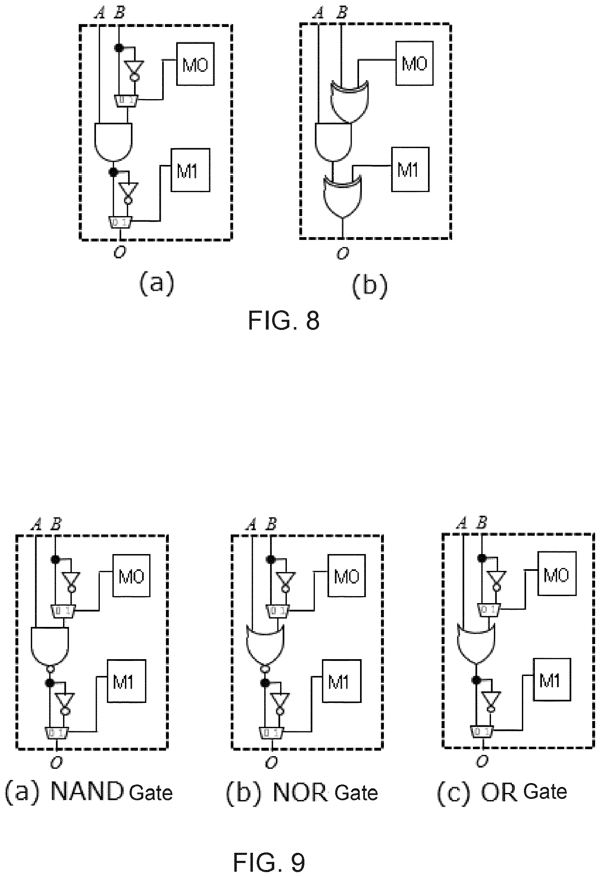

Therefore, firstly, a programmable NOT circuit of the PA circuit shown in Fig. 3 (b) may be implemented with NOT gates and multiplexers as in Fig. 8 (a), or may be implemented with XOR gates as in Fig. 8 (b). Also, in cases other than when an original netlist uses AND gates, NOT gates for basic logic elements, configurations using other logic elements as Px circuits may be employed. Fig. 9 are embodiment examples of a Px circuit with (a) a NAND gate, (b) a NOR gate, and (c) an OR gate, respectively, as a basic logic operation element.

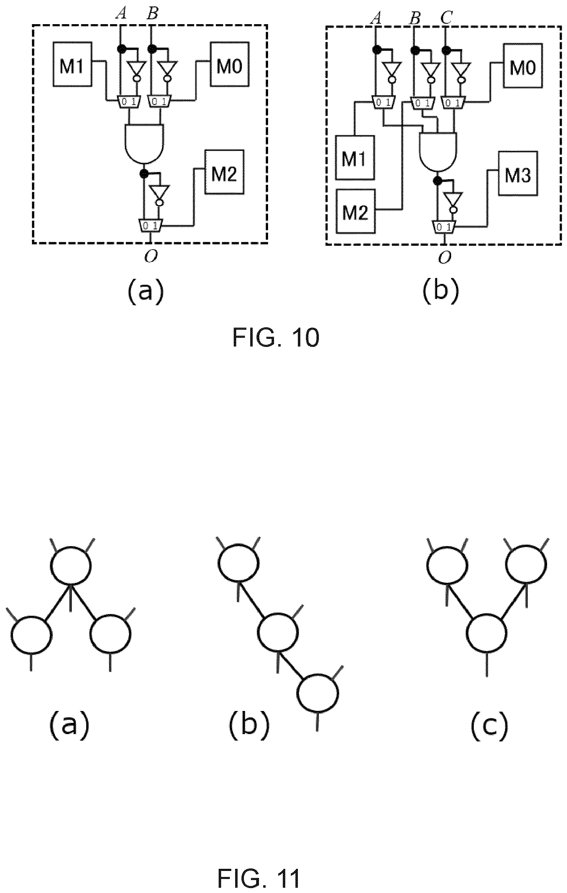

Also, as shown in Fig. 10 (a), for every input of a Px circuit, a programmable NOT circuit may be disposed. Further, Fig. 10 (b) is an example using an AND gate with three inputs to its basic logic cell. As such, the number of inputs to a basic logic cell is not limited to two.

### 4. Combinational Logic Cell

The combinational logic cell discussed in the above section on the basic concepts of the present invention was of four inputs and three outputs, but as the number of inputs of a basic logic cell is not limited to two, the number of inputs of a combinational logic cell is not limited to four inputs and three outputs either.

In other words, according to the present embodiment, if a combinational logic cell is configured with a combination of two or more types of graphs, wherein each graph has n basic logic cells connected to one another, wherein each of the basic logic cells has m inputs, then, the number of inputs is (m-1)×n+1, and the number of outputs is n. Here, m and n may be any numbers equal to or greater than two, respectively.

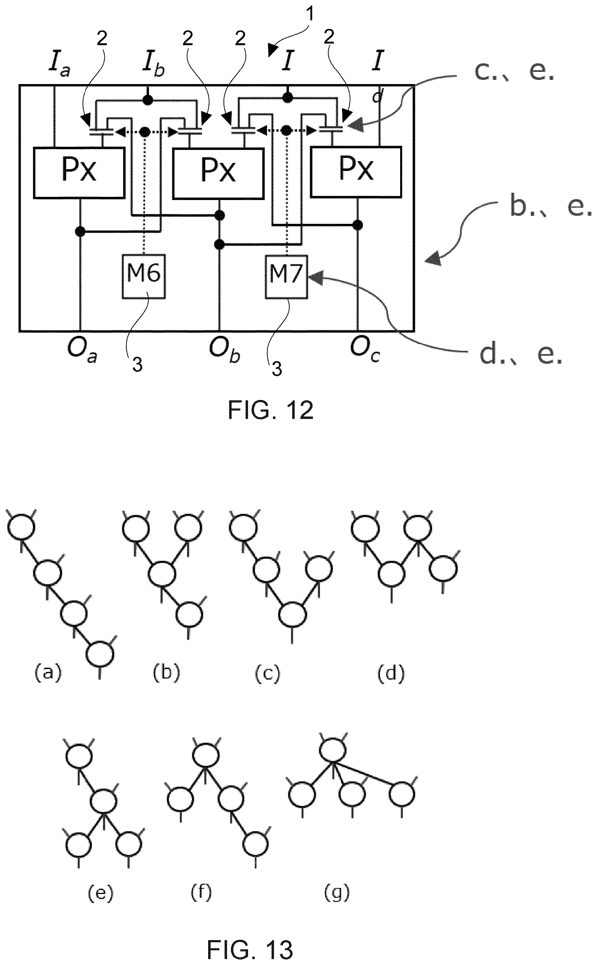

Fig. 12 shows a combinational logic cell 1 with the number of inputs m of a basic logic cell (Px) being two and the number of connected cells being three. The number of inputs of this combinational logic cell 1 is (m-1)×n+1=(2-1)×3+1=4, and the number of outputs is n, that is, three.

Also, connection relationships of a graph with the number of inputs of the basic logic cell m=2, and n=3 of the basic logic cells being connected, will have three patterns as in Figs. 11 (a)-(c) (circles indicate the basic logic cells). The present combinational logic cell 1 has functionality (indicated with a reference number 2 in Fig. 12) to switch the connection relationships of internal logic nodes with a multiplexer or an equivalent circuit in order to implement such a plurality of node connection relationships. Also, the present combinational logic cell 1 has memories (reference number 3 in Fig. 12) for retaining switching information of the multiplexer or the like for the connection switching, and is adapted so that it may configure internal memories of the logic cells according to the connection shapes of the nodes constituting the netlist.

Note that the basic logic cell (Px circuit) may be not only the aforementioned Px circuit including programmable NOT circuits, but also a single NAND gate, NOR gate, or the like.

Other embodiments of the combinational logic cell implemented according to the values of m and n will be discussed.

Example of n=4 of basic logic cells connected, each with the number of inputs m=2

A graph with the number of inputs of the basic logic cell m=2, and n=4 of them being connected, will have seven patterns as in Figs. 13 (circles indicate the basic logic cells (PX circuits)).

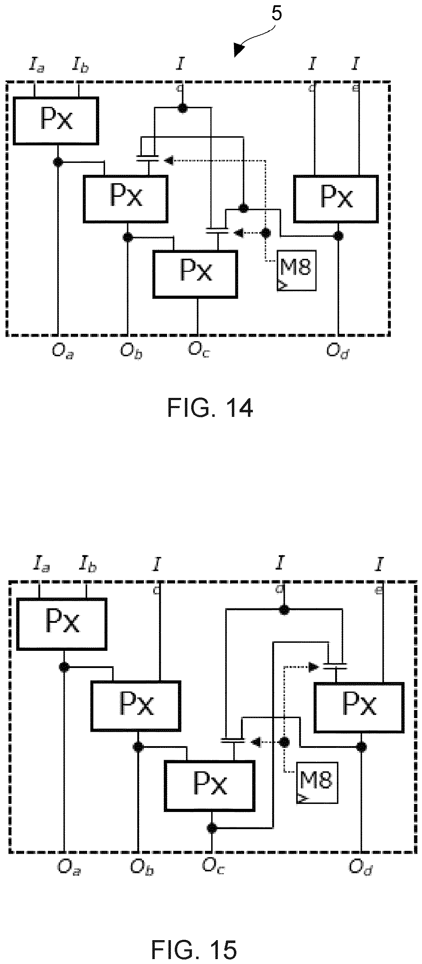

Of these seven patterns, combinational logic cells of (2-1)×4+1=5 inputs and four outputs generated by combining the two types of Fig. 13 (b) and Fig. 13 (c) will be configured, for example, as indicated with a reference number 5 in Fig. 14. Here, the basic logic cell Px may also be a single NAND gate, NOR gate, or the like as discussed above.

Fig. 15 shows an embodiment example of a logic cell of 5 inputs and 4 outputs generated by combining the two types of Figs. 13 (a) and (c) out of the seven patterns.

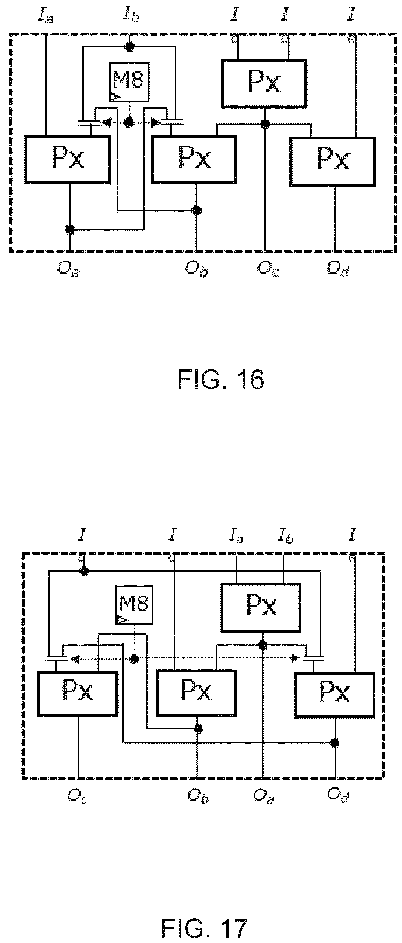

Similarly, Fig. 16 shows an embodiment example of a combinational logic cell of Figs. 13 (c) and (d). Fig. 17 is an embodiment example of a combinational logic cell of Figs. 13 (c) and (f). Note that similar to the above, the basic logic cell (Px circuit) may also be a single NAND gate, NOR gate, or the like.

Examples of logic cells configured by combining three or more types of basic logics

In the above examples, connection relationships of two types of basic logic cells (nodes) were implemented in one combinational logic cell, but the number of basic logic cell types are not limited to two, and connection relationships of more than two types may be implemented in one combinational logic cell.

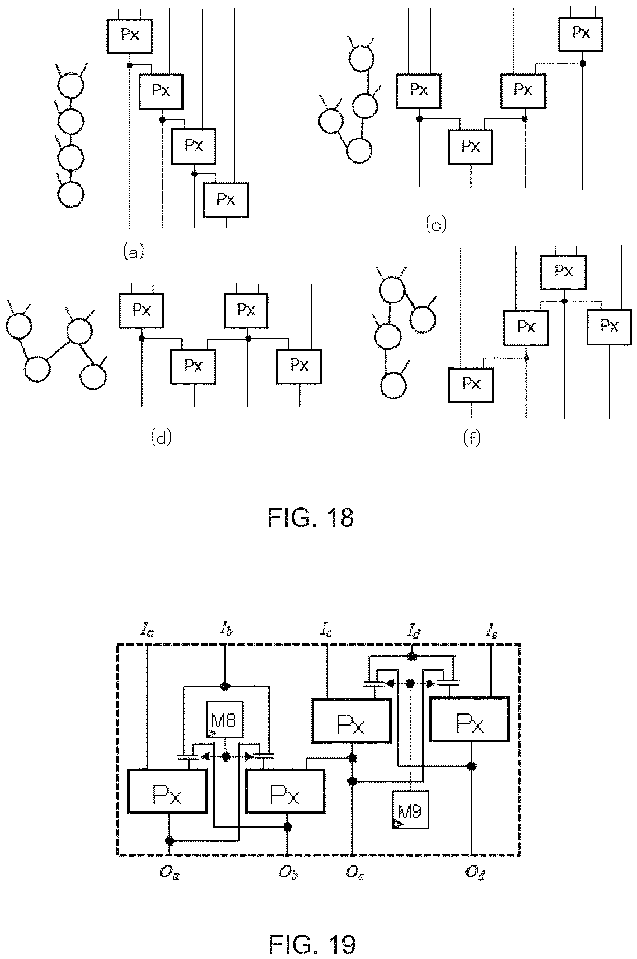

Figs. 18 are embodiment examples of logic cells implementing four patterns of node connection relationships of Figs. 13 (a), (c), (d), (f). In turn, Fig. 19 is a configuration example of a combinational logic cell implementing these four patterns of node connection relationships.

Note that the above example is for the case where the number of included basic logic cells is four, but the number of inclusions n is also arbitrary.

### 5. Technology Mapping Method of the Present Embodiment

Next, a technology mapping method using the above combinational logic cell in the present embodiment will be described.

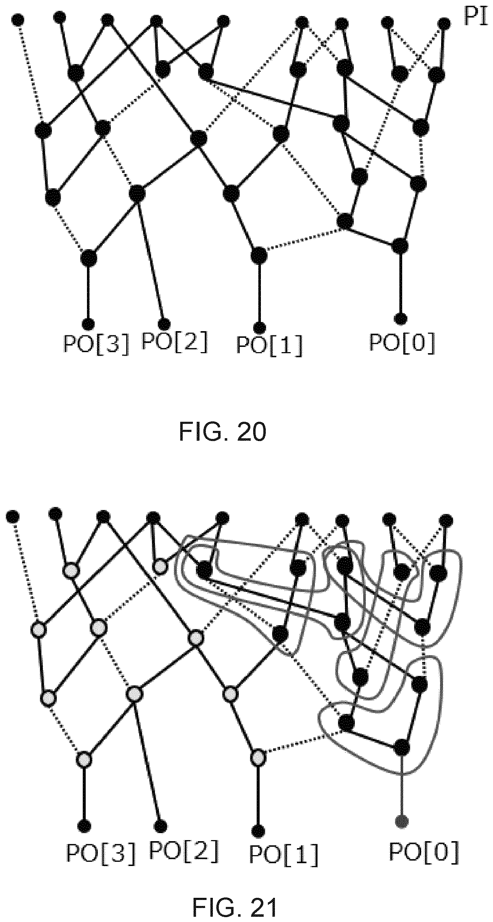

When a netlist (AIG) as shown in Fig. 20 is given, a technology mapping procedure using typical LUTs is as follows.
(1) Based on the graph theory, decompose a Directed Acyclic Graph (DAG) of AIG to a tree or trees;
(2) Map a tree to LUTs;
(3) Select the next tree and return to the above (2); and
(4) End when all the trees are mapped.

Here, when mapping the tree to LUTs in the above (2), a minimum coverage is explored, but since there are a plurality of nodes overlapping due to the decomposition into the tree; and therefore, those overlapping nodes will be mapped to different LUTs, respectively. For this reason, the number of post-mapping LUTs will increase depending on the degree of overlap.

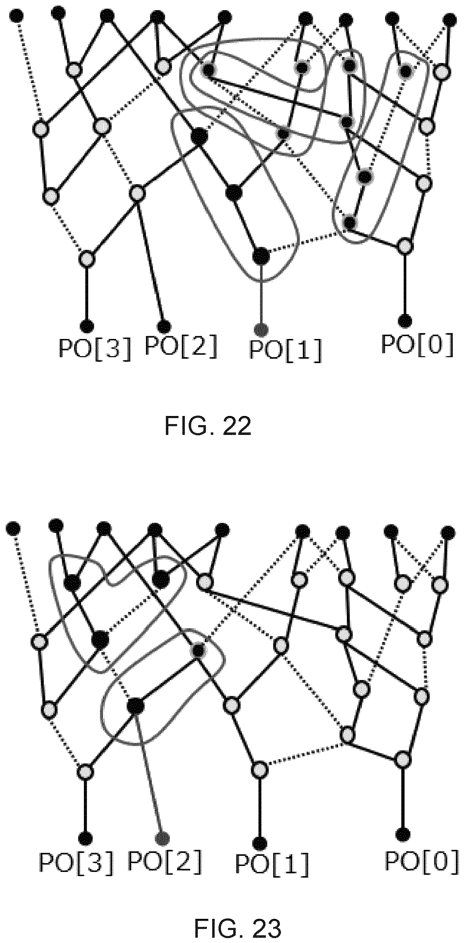

In other words, the DAG of the AIG as shown in Fig. 20 may be decomposed to trees, as shown in Figs. 21-24, with the input signals PO as vertices. Since each tree is independently mapped to LUTs, a plurality of nodes are shared between two trees, and mapped a plurality of times to LUTs. As a result, total 14 LUTs will be required. Consequently, required component memory amount will be 16 bits×14, that is, 224 bits.

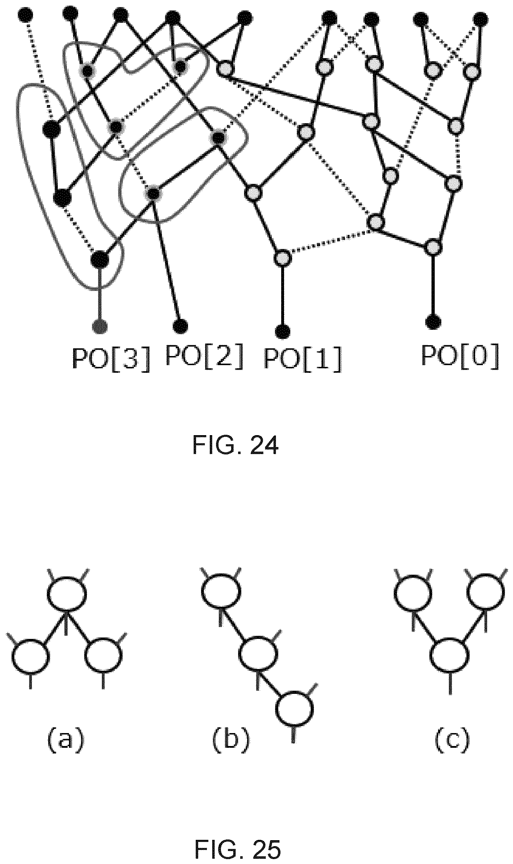

Whereas, a procedure of the technology mapping using the logic cells of the present embodiment is as below.
(1) Within the AIG, conduct matching with any of the node graphs of Figs. 25(a), (b), (c);
(2) Perform mapping to logic cells;
(3) Return to (1) until all the nodes are covered; and
(4) End when all the nodes are mapped.

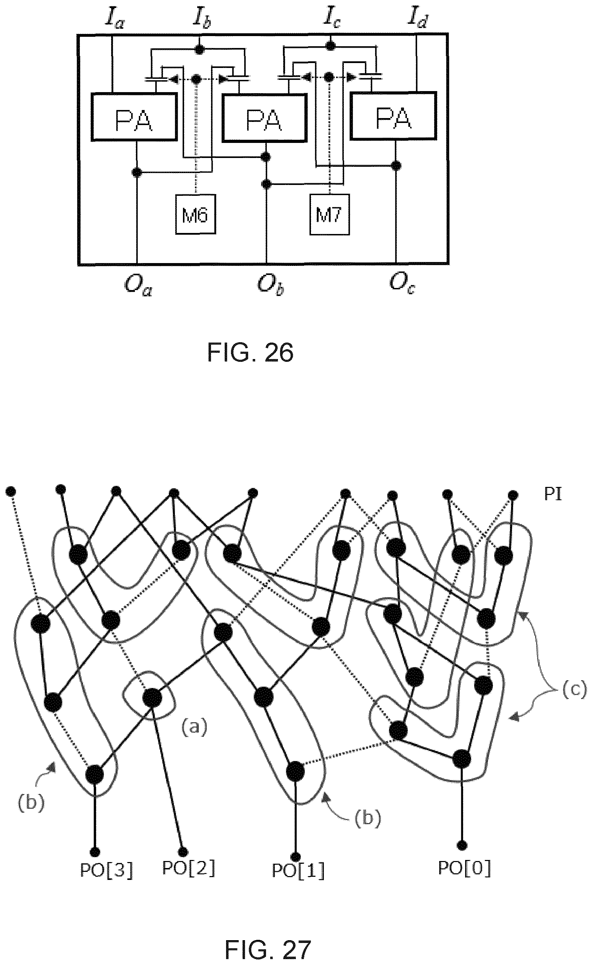

Mapping the netlist, shown in Fig. 20, which is the same as the above conventional mapping method, using a 4-input, 3-output combinational logic cell, shown in Fig. 26, will result as shown in Fig. 27. When mapping to the logic cell of the present embodiment, outputs from nodes within covered ranges are utilizable, thus, coverage of nodes in question does not overlap. As a result, in this example, mapping may be done with eight of the 4-input, 3-output combinational logic cells (the number of component memories is 8 bits), and the amount of component memories will be 8 bits×8, that is, 64 bits. This is 1/3 or less compared to when using the 4-LUT.

According to the configuration discussed above, there is provided a programmable logic circuit (PAE and combinations thereof), comprising basic logic cells (PX circuits) for an embedded FPGA onboard an ASIC, for configuring nodes of a gate-level netlist, wherein these basic logic cells are programmable circuits configured by adding programmable NOT circuits to basic logic operation elements, and made programmable to switch inputs and outputs of the basic logic cells depending on connection relationships of the nodes in the netlist.

According to such a configuration, the number of memories constituting the logic may be reduced to a number generally proportional to the number of inputs. Accordingly, the logic may be constituted with a very small number of memories compared to when the logic is constituted with the conventional SRAM-based LUTs. Also, since the speed of the implemented logic circuit depends on the netlist, the effect of speed increase due to the number of logic cell levels is small unlike when constituted with conventional LUTs.

It should be noted that the present invention is not limited to the above one embodiment, and that various changes and modifications may be made without departing from the spirit and scope of the present invention.

### Description of the Reference Numbers

1: Combinational logic cell
2: Multiplexer
3: Memory
5: Combinational logic cell
PA: Basic logic cell
PX: Basic logic cell

## Claims

1. A programmable logic circuit, comprising:
a basic logic cell for configuring a plurality of nodes of a gate-level netlist,
wherein the basic logic cell is a programmable circuit configured by adding one or more programmable NOT circuits to a basic logic operation element and made programmable to switch inputs and outputs of the basic logic cell depending on connection relationships of nodes in the gate-level netlist.

2. The programmable logic circuit of Claim 1, further comprising:
a combinational logic cell composed of a combination of a plurality of the basic logic cells,
wherein the combinational logic cell comprises a plurality of basic logic cells for covering a plurality of nodes constituting a graph of the netlist.

3. The programmable logic circuit of Claim 2, wherein
the combinational logic cell is a logic cell of (m-1)×n+1 inputs and n outputs, having n of m-input basic logic cells with their input signals switch-ably combined and connected, in order to represent two or more patterns of node connections.

4. The programmable logic circuit of Claim 3, wherein
the combinational logic cell comprises:
a switching circuit for switching connection relationships of basic logic nodes in order to implement two or more patterns of node connections.

5. The programmable logic circuit of Claim 4, wherein
the switching circuit is a multiplexer.

6. The programmable circuit of Claim 3, further comprising:
a memory for retaining switching information of the switching circuit,
wherein the switching information is information for programming the basic logic cells according to the connection relationships of the nodes constituting the netlist.

7. A method for configuring a programmable logic circuit, wherein
nodes constituting a gate-level netlist are assigned to a programmable logic cell, and
the programmable logic cell is made programmable to switch inputs and outputs of the logic cell depending on connection relationships of the nodes.

8. The method for configuring a programmable logic circuit of Claim 7, comprising the steps of:
assigning the gate-level netlist to a combinational logic cell composed of a combination of n of m-input basic logic cells, wherein the combinational logic cell covers n nodes constituting a graph of the netlist; and
configuring the combinational logic cell, the n of m-input basic logic cells, as a logic cell of (m-1)×n+1 inputs and n outputs with their input signals switch-ably combined and connected, in order to represent two or more patterns of connection relationships among the covered plurality of nodes.

9. The method of Claim 8, further comprising the step of
assigning the basic logic cells to nodes of a gate-level netlist,
wherein the basic logic cells are programmable circuits configured by adding programmable NOT circuits to basic logic operation elements, and
made programmable to switch inputs and outputs of the basic logic cells depending on connection relationships of the nodes in the netlist.

10. The method of Claim 8, further comprising the step of
disposing a switching circuit for switching connection relationships of basic logic nodes between the basic logic nodes in the combinational logic cell in order to implement two or more patterns of node connections.

11. The method of Claim 9, further comprising the step of
programming switching information of the connection relationships in the basic logic cells according to the connection relationships of the nodes constituting the netlist.
